Europäisches Patentamt

European Patent Office

Office européen des brevets

(19)

(11) Numéro de publication: **0 030 899**
**B1**

(12) ## FASCICULE DE BREVET EUROPEEN

(45) Date de publication du fascicule du brevet:
**30.05.84**

(51) Int. Cl.³: **G 03 B 41/00**

(21) Numéro de dépôt: **80401808.3**

(22) Date de dépôt: **17.12.80**

(54) Système d'alignement optique de deux motifs comportant des repères d'alignement du type réseaux, notamment en photorépétition directe sur silicium.

(30) Priorité: **18.12.79 FR 7930936**

(43) Date de publication de la demande:
**24.06.81 Bulletin 81/25**

(45) Mention de la délivrance du brevet:
**30.05.84 Bulletin 84/22**

(84) Etats contractants désignés:
**DE GB NL**

(56) Documents cités:
**I.E.E.E. TRANSACTIONS ON ELECTRONIC DEVICES,
vol. ED-26, no. 4, 1979 NEW YORK (US) G. BOUWHUIS et
al.: "Automatic aligning system for optical projection
printing" pages 723-728**

(73) Titulaire: **THOMSON-CSF, 173, Boulevard Haussmann,
F-75379 Paris Cedex 08 (FR)**

(72) Inventeur: **Lacombat, Michel, THOMSON-CSF
SCPI 173, bld Haussmann, F-75360 Paris Cedex 08 (FR)**

(74) Mandataire: **Lepercque, Jean et al, THOMSON-CSF
SCPI 173, Bld Haussmann, F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention se rapporte à un système optique permettant l'alignement automatique de deux motifs comportant des repères d'alignement de type réseaux optiques. L'invention s'applique notamment à la photo-répétition directe sur silicium.

La fabrication de circuits intégrés implique la réalisation sur un substrat de fenêtres permettant de localiser l'implantation ou le traitement. Ce substrat est recouvert d'une couche de résine photosensible. La réalisation de fenêtres se fait par masquage de cette résine à partir d'un masque porté par un réticule. Antérieurement, il a été utilisé comme méthode de transfert le contact direct ou la proximité. Les procédés actuels mettent en œuvre la technique de transfert par projection optique.

Cette projection peut être effectuée au rapport 1/1, le masque étant alors globalement projeté sur la plaquette. Cette projection peut également être effectuée par partition de l'image: soit par analyse du masque par une fente mobile, soit par utilisation de la technique de photo-répétition au rapport 1/n.

Dans la technique de fabrication de circuits par photo-répétition directe, chaque motif à réaliser est projeté directement sur la plaquette semi-conductrice préalablement recouverte d'une couche de résine photo-sensible, suivant un programme préétabli, la position de la plaquette étant contrôlée par interférométrie suivant deux directions X, Y. De manière classique, la photorépétition est effectuée en décalant la plaquette suivant deux directions X et Y orthogonales.

Dans tous les cas on doit positionner, l'un par rapport à l'autre et de façon très précise, la réticule et la plaquette en matériau semi-conducteur sur laquelle doit être réalisé le circuit intégré. Pour ce faire, de nombreux procédés d'alignement ont été proposés. En général, il est fait appel à des motifs supplémentaires comprenant des repères d'alignement portés respectivement par le réticule et par la plaquette semi-conductrice. Selon le procédé mis en œuvre, le nombre de ces repères, leur disposition ou leur configuration doivent être tels qu'ils permettent l'alignement selon deux axes de référence X, Y et l'alignement angulaire de la plaquette semi-conductrice.

Une des méthodes les plus répandues consiste à superposer des repères d'alignement portés sur le masque et sur la plaquette semi-conductrice, par l'intermédiaire de l'optique de transfert et d'observer cette superposition avec un microscope à deux objectifs, du type dit «Split-Field». L'œil de l'opérateur peut être avantageusement remplacé par un tube vidicon pour visualisation sur écran de télévision.

Suivant une technique plus élaborée, le signal vidéo obtenu par la caméra de télévision peut être traité pour obtenir un signal analogique ou numérique, utilisable par des circuits d'asservissement. Certains procédés utilisent par exemple le balayage d'une croix de St-André et de son complément pour déterminer l'écart à l'alignement qui se traduit par un invervalle entre les fronts des signaux.

Les dispositifs mettant en œuvre les procédés de l'art antérieur présentent deux inconvénients majeurs:
- le champ des repères d'alignement portés par le masque et la plaquette semi-conductrice est entièrement éclairé et, aux images de ces repères, se superpose un niveau de bruit non négligeable (réflexion parasite, diffusion, diffraction) qui conduisent à un mauvais rapport signal/bruit;
- le contraste des repères silicium est très variable d'un niveau d'intégration à l'autre, compte tenu des variations d'épaisseur d'oxyde ou de la nature des dépôts (silicium polycristallin, aluminium). La qualité de l'alignement est donc essentiellement variable. Elle dépend du contraste d'une part et d'autre part, soit de l'acuité visuelle de l'opérateur, soit du pouvoir de résolution de l'électronique associée.

Pour pallier ces inconvénients, il a été proposé d'utiliser comme repère d'alignement des trames ou des réseaux optiques à pas constant ou, au contraire, à pas variable, par exemple suivant un code pseudo-aléatoire tel que les codes du type code de BARKER. Un tel procédé est décrit notamment dans la demande de brevet européen au nom de la demanderesse publiée sous le numéro EP-A1-0 015 173 le 3 septembre 1980.

Selon le procédé décrit dans cette demande, un premier motif constitué par deux réseaux optiques, disposés suivant deux axes de coordonnées (X, Y), est éclairé par l'image d'un second motif comprenant deux réseaux optiques, formant référence, et produit des ordres de diffraction. Selon une des variantes de cette demande de brevet, les réseaux optiques sont constitués d'une suite de traits parallèles dont l'épaisseur et la répartition spatiale suivant une première direction (C) sont déterminées par un code pseudo-aléatoire; les traits des réseaux optiques du premier motif étant en outre interrompus périodiquement suivant une seconde direction (R) pour former un réseau optique à pas constant. Le système optique d'alignement comprend des moyens opto-électroniques de détection de l'intensité d'une partie prédéterminée des ordres de diffraction suivant la direction (R).

Il est également connu que l'alignement puisse se faire «directement», c'est-à-dire à la suite de la projection de l'image des réseaux portés par le réticule sur les réseaux portés par la plaquette semi-conductrice, ou au contraire «séquentiellement» en utilisant un motif d'alignement intermédiaire, lié au châssis du photo-répéteur. Un tel procédé est aussi décrit dans la demande de brevet précitée.

Il est enfin également connu que si l'on désire mettre en œuvre un alignement automatique, il est nécessaire de créer des signaux électriques utilisables par des circuits électroniques d'asservissement associés au photo-répéteur. Ces circuits agissent habituellement sur des moyens d'entraînement d'une table supportant la plaquette semi-conductrice. Parmi ces signaux, il est connu d'utiliser un signal bipolaire en forme de S allongé passant par zéro lorsque l'alignement est obtenu. Pour obtenir ce résultat, il est nécessaire, notamment, de moduler les signaux de sortie des moyens opto-électroniques de détection.

Dans l'art connu, les moyens mis en œuvre pour obtenir cette modulation sont généralement de type mécanique. On peut citer à titre d'exemples non limitatifs la modulation angulaire de l'angle de réflexion du faisceau de rayons lumineux utilisé pour l'alignement par un miroir oscillant, le passage de ce faisceau au travers d'une lame optique également animée d'un mouvement oscillatoire ou la mise en vibration linéaire autour d'un point de repos de la plaquette semi-conductrice. Ce dernier effet peut être obtenu à l'aide de moteurs de type piézoélectrique dont est généralement munie la table de translation X, Y portant la plaquette semi-conductrice.

Parmi ces procédés, celui décrit dans la publication «I.E.E.E. Transactions on Electronic Devices», vol. ED-26, N° 4, 1979, pages 723–728 décrit notamment une méthode de détection dynamique pour réaliser l'alignement, faisant usage d'un système de modulation de signaux électriques passant par zéro lorsque l'alignement est réalisé. Le faisceau d'alignement provenant du réseau inscrit sur la plaquette à aligner est divisé en deux rayons, ordinaire et extraordinaire, de directions de polarisation orthogonales entre elles, à l'aide d'un élément biréfringent placé sur le faisceau d'alignement, ces deux rayons éclairant simultanément un seul réseau de masque. Il y a nécessité, selon ce procédé, d'introduire un élément optique sur le trajet du faisceau de rayons lumineux, ce qui provoque l'apparition d'aberrations optiques.

Ces procédés présentent un certain nombre d'inconvénients et parmi lesquels: l'inertie inhérente à tout système mécanique, la difficulté d'obtenir un zéro stable (point de repos bien défini) ou pour une partie de ces procédés, notamment pour le procédé dernièrement rappelé, l'apparition d'aberrations optiques dues à l'introduction de moyens optiques sur le trajet du faisceau de rayons lumineux servant à l'alignement et traversés par ces rayons.

Pour pallier ces inconvénients, l'invention a donc pour objet un système d'alignement optique d'au moins un premier motif porté par un support mobile par rapport à un second motif porté par un support fixe, formant référence; les premier et second motifs comprenant chacun au moins un repère d'alignement du type constitué par au moins un réseau optique à pas constant, le système comprenant en outre des moyens optiques de grandissement déterminé destinés à projeter l'image du réseau formant le repère d'alignement du second motif sur le réseau formant le repère d'alignement du premier motif, cette projection produisant des ordres de diffraction dont l'intensité lumineuse est représentative de l'état d'alignement atteint, ainsi que des moyens optoélectroniques pour détecter l'intensité lumineuse de l'un des ordres de diffraction, différent de zéro, ainsi produits; système caractérisé en ce que le repère d'alignement du second motif comprend au moins un couple de deux réseaux optiques identiques constitués chacun par une suite de traits parallèles à un premier axe de symétrie et situés de part et d'autre de cet axe, en étant séparés l'un de l'autre d'une distance prédéterminée, cette distance étant choisie de façon à être différente d'un multiple entier du pas commun aux deux réseaux dudit couple, et l'extension transversale totale dudit couple étant par ailleurs choisie relativement à celle dudit réseau correspondant porté par le support mobile et au grandissement des moyens de projection, de façon que l'image dudit couple de réseaux dans le sens transversal soit superposable par projection dans sa totalité sur ledit réseau correspondant, et en ce que deux fenêtres délimitent deux portions, respectivement des premier et second réseaux optiques, ledit système comportant en outre des moyens optiques comprenant une source d'énergie lumineuse produisant un faisceau d'alignement chargé d'illuminer lesdites fenêtres et un commutateur sélectif disposé sur le trajet dudit faisceau d'alignement et recevant un signal de commande de fréquence déterminée pour illuminer alternativement à cette fréquence l'une et l'autre fenêtres, et assurer ainsi la projection en alternance, sur ledit réseau correspondant porté par le support mobile, de l'image de l'une et l'autre portions desdits premier et second réseaux délimitées par lesdites fenêtres, ladite projection alternée entraînant ainsi l'élaboration en sortie des moyens opto-électroniques d'un signal dont le niveau normalement diffère d'une alternance à l'autre du signal de commande, et ledit signal de sortie étant en outre transmis à des moyens électroniques de comparaison établissant ladite différence de niveau de ce dernier d'une alternance à l'autre, l'alignement étant alors obtenu lorsque ladite différence de niveau devient nulle d'une alternance à l'autre.

L'invention sera mieux comprise et d'autres caractéristiques et avantages apparaîtront à la lecture de la description qui suit en référence aux figures annexées, parmi lesquelles:
- la fig. 1 illustre schématiquement un système optique d'alignement selon l'invention;
- les figs 2 à 4 illustrent des points de détail ou des aspects particuliers du système de l'invention;
- les figs 5 à 7 sont des diagrammes illustrant le fonctionnement du système de l'invention;
- la fig. 8 illustre schématiquement les circuits électroniques de la boucle d'asservissement mise en œuvre dans le système de l'invention;
- la fig. 9 décrit une cellule opto-électronique du type cellule de Pockels utilisée par l'invention;
- les figs 10 à 16 illustrent trois variantes de procédés permettant d'obtenir un pré-alignement.

Il est tout d'abord utile de rappeler le procédé permettant d'aligner, l'un par rapport à l'autre, deux motifs constitués chacun par un couple de réseaux optiques, procédé décrit par exemple dans la demande de brevet européen EP-A-15 173 précitée. On supposera en outre pour fixer les idées, ce sans que cela limite la portée de l'invention, que l'alignement s'effectue selon la seconde approche qui a été rappelée, à savoir «séquentiellement» en faisant usage d'un ou plusieurs motifs intermédiaires liés au châssis d'un photo-répéteur.

Selon cette approche, le réticule portant, outre un motif à projeter (ou à transférer) sur la plaquette semi-conductrice, un motif comprenant au moins un couple de repères d'alignement est positionné de façon précise par rapport à un motif intermédiaire fixe comprenant, par exemple, un premier couple de repères optiquement complémentaires. Ce motif intermédiaire comprend un second couple de repères d'alignement utilisés dans une phase ultérieure pour positionner de façon précise la plaquette semi-conductrice par rapport à ce motif intermédiaire.

On suppose également que la première phase d'alignement est effectuée de façon classique et que seuls le second couple de repères d'alignement et les repères portés sur la plaquette semi-conductrice sont du type réseaux optiques. L'invention sera donc décrite dans le cadre de cette deuxième phase de l'alignement de deux motifs.

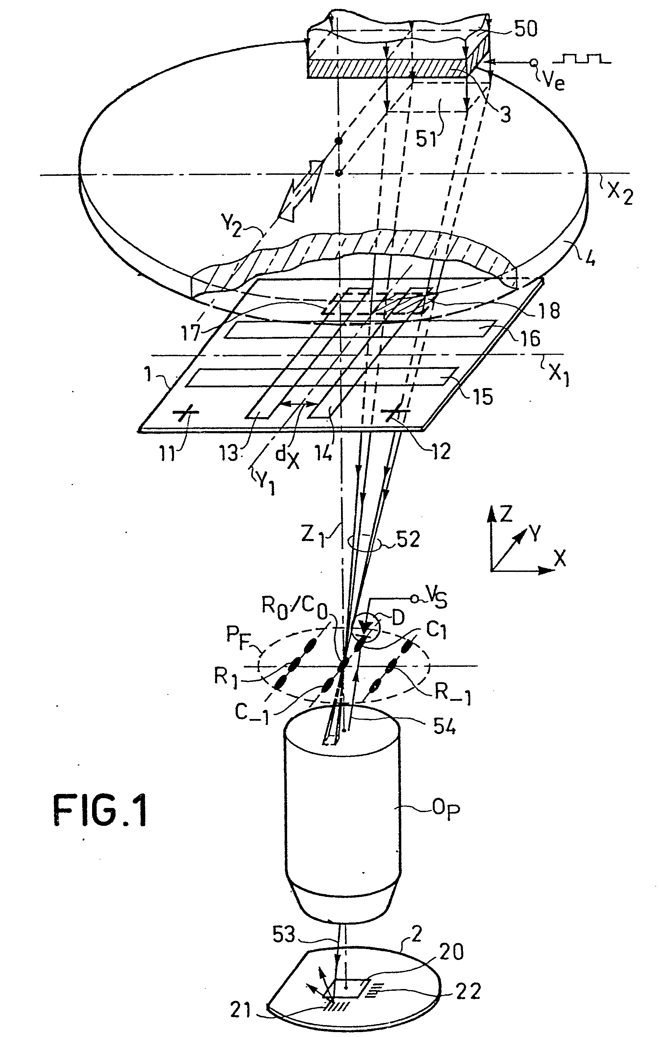

Les figs 1 à 4 illustrent un exemple de réalisation d'un système d'alignement optique conforme à l'invention. Une plaquette de silicium 2 sur laquelle doivent être projetés en 20 des motifs portés par un réticule (non représenté) doit être alignée par rapport à un motif intermédiaire porté par le support 1 lié au châssis du photo-répéteur. Pour ce faire, le support 1 et la plaquette 2 portent des réseaux 13–14 et 15–16, respectivement 21 et 22, qui vont servir à l'alignement de la plaquette par rapport au support 1. Le support 1 et la plaquette 4 sont situés dans des plans perpendiculaires à l'axe optique $Z_1$ d'un objectif de projection $O_P$. Les repères servant à l'alignement sont des réseaux optiques constitués par des traits parallèles à deux axes préférentiels X et Y orthogonaux entre eux. Les repères 13–14 et 15–16 sont des réseaux. Les repères 21 et 22 sont également des réseaux de même nature que les réseaux du support 1. D'autre part les traits composant ces réseaux 21 et 22 sont interrompus de façon régulière, suivant une seconde direction (orthogonale à la première direction), et forment de ce fait un réseau à pas régulier suivant cette direction. Sur la fig. 1, seul l'alignement des réseaux a été illustré suivant l'axe X; l'alignement suivant l'axe Y étant identique.

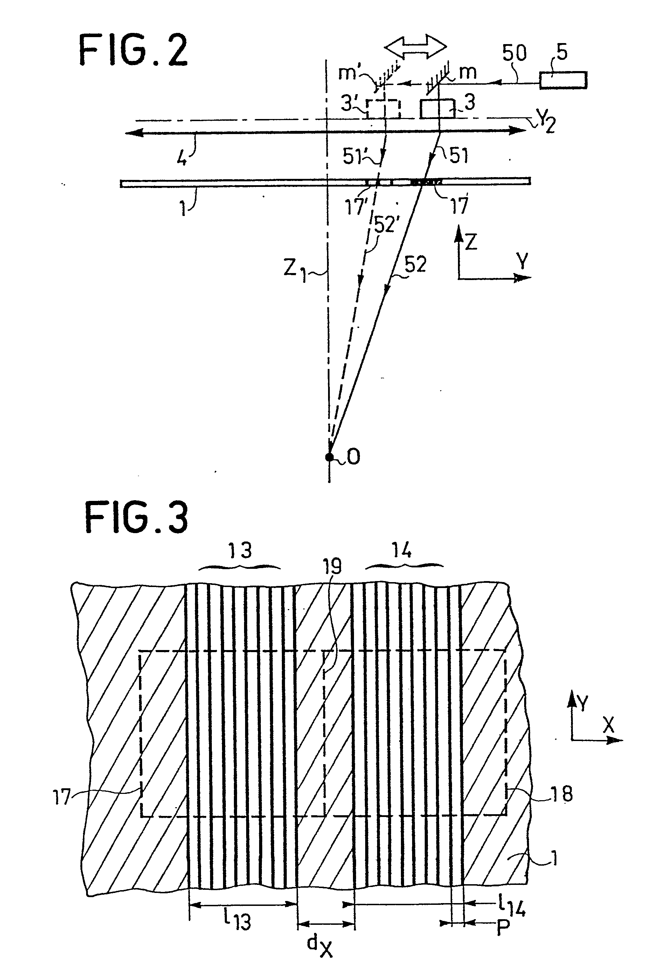

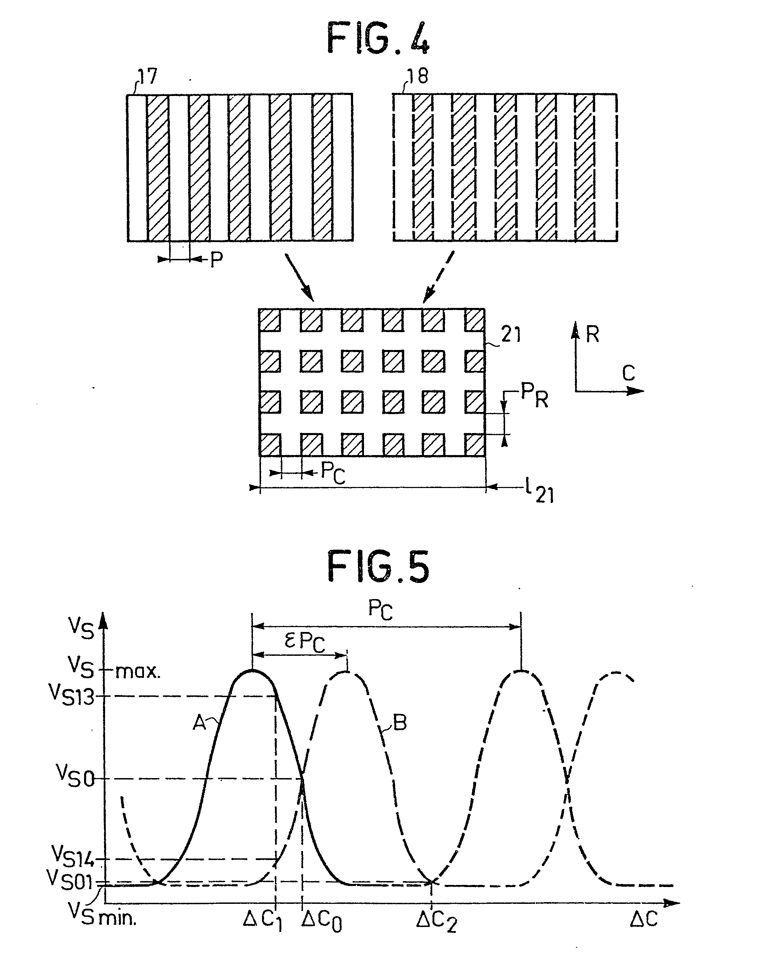

Dans le cadre de l'invention, les réseaux utilisables ont un pas constant suivant la direction C. De tels réseaux sont illustrés plus particulièrement par les figs 3 et 4. Selon un des aspects les plus importants de l'invention les réseaux portés par le support 1 sont en fait constitués de couples de réseaux identiques, respectivement 13 et 14, et 15 et 16. Ces réseaux sont disposés parallèlement à deux axes de symétrie $X_1$ et $Y_1$, et de part et d'autre à égale distance de ces axes, selon la disposition illustrée par la fig. 1, les axes $X_1$ et $Y_1$ étant pour leur part parallèles respectivement aux axes X et Y.

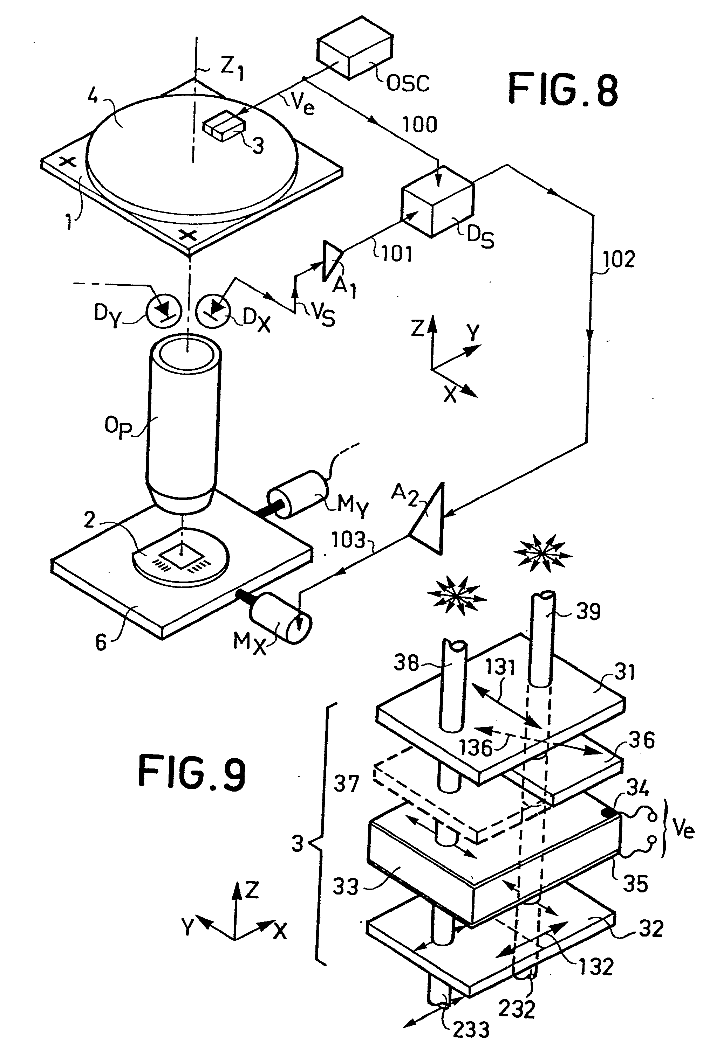

D'autre part, selon un second aspect de l'invention, seules des fenêtres 17–18 définies sur ces réseaux sont éclairées, ce en alternance. Il s'en suit que les images de ces fenêtres (17 ou 18) sont projetées à tour de rôle sur le réseau correspondant 21 porté par la plaquette semi-conductrice 2. Cette projection s'effectue à l'aide de l'objectif de projection $O_P$, utilisé par ailleurs pour le transfert des motifs à inscrire dans la zone 20 de la plaquette semi-conductrice 2. Le réseau 21, éclairé en partie par l'image de l'un des réseaux 13 ou 14, va produire des ordres de diffraction suivant deux directions privilégiées, c'est-à-dire suivant les directions C et R, ou ce qui revient au même, suivant les directions X et Y. Les ordres de diffraction peuvent être détectés dans le plan de Fourier $P_F$. On a représenté dans ce plan de Fourier $P_F$ les ordres de diffraction $C_0$, $C_1$, $C_{-1}$ et suivant l'autre direction $R_0$, $R_1$, $R_{-1}$. L'ordre de diffraction $R_1$ est détecté par un moyen opto-électronique D. Les signaux de sortie $V_S$ de ce moyen opto-électronique de détection sont transmis à des moyens électroniques qui seront décrits ultérieurement au regard de la fig. 8. On peut également détecter l'ordre $R_{-1}$ ou tout autre ordre $R \pm n$ différent de l'ordre $R_0$ qui se confond avec l'ordre $C_0$. Le réseau 22 pour l'alignement de la voie Y va diffracter dans des directions orthogonales aux directions de diffraction du réseau 21. Les ordres $R_1$ ou $R_{-1}$ ou tout autre ordre $R \pm n$ du réseau 22 peuvent être détectés sur l'axe X. Cette technique permet de discriminer spatialement les signaux d'alignement X et d'alignement Y, si les pas des réseaux dans les directions R et C sont distincts. Sinon la discrimination peut, par exemple, être réalisée en utilisant deux polarisations orthogonales de la lumière pour les réseaux X et Y. Les détecteurs de voies X et Y sont alors équipés d'analyseurs permettant de sélectionner uniquement la lumière correspondante à la direction observée.

Le plan de Fourier $P_F$ est en général confondu avec l'image de la pupille d'entrée de l'objectif de projection $O_P$.

Le phénomène qui vient d'être décrit se réalise quelle que soit l'image des réseaux 13 ou 14 (délimités par les fenêtres 17 ou 18) projetée sur le réseau 21. Les signaux de sorties en tension $V_S$ délivrés par les moyens opto-électroniques D sont représentés sur le diagramme de la fig. 5, en fonction des positions relatives de l'image du réseau 13 (fenêtre 17) et du réseau 21: courbe A en trait plein, ou de l'image du réseau 14 (fenêtre 18) et du réseau 21: courbe B en pointillée. L'axe ΔC représente le désalignement selon la direction C.

Il faut naturellement tenir compte du grandissement G de l'objectif $O_P$, en général de l'ordre de $1/5$ à $1/10$ (en valeur absolue) pour déterminer le pas $P_C$ (pas du réseau 21 dans la direction C). On doit vérifier la relation:

$$P_C = |G| \cdot P \qquad (1)$$

P étant le pas des réseaux 13 et 14.

D'autre part, si $d_X$ est la distance qui sépare les deux réseaux 13 et 14 et $1_{13}$ et $1_{14}$ leurs largeurs respectives, égales à une valeur commune 1, la largeur $1_{21}$ du réseau 21 suivant la direction C doit être telle que la relation suivante soit vérifiée:

$$1_{21} \geqslant |G| \cdot (21 + d_X) \qquad (2)$$

Le pas du réseau suivant la direction R est égal à $P_R$.

D'autre part, $d_X$ est donné par la relation:

$$d_x = P(n + \varepsilon) \qquad (3)$$

où P est le pas des réseaux 13 et 14, n étant un nombre entier et une fraction de l'unité (par exemple 0,25).

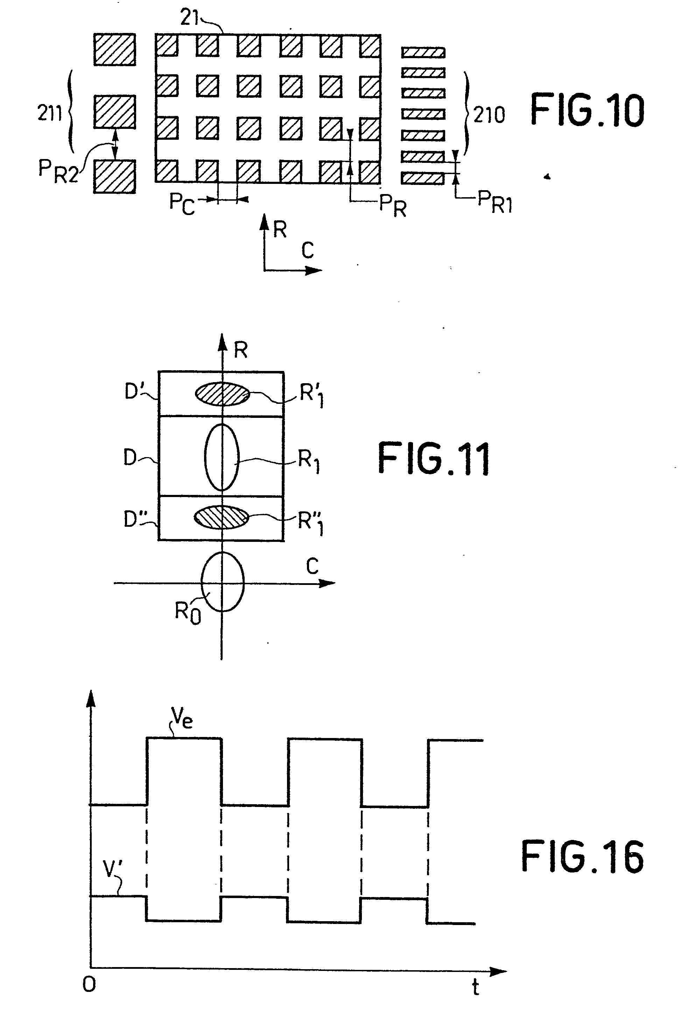

Si on revient à la fig. 5 représentant les signaux détectés par D dans l'ordre $R_1$ (ou $R_{-1}$), on constate que les courbes A et B représentant ces signaux sont périodiques, non sinusoïdales et décalées l'une 2 par rapport à l'autre de $\varepsilon \cdot P_C$. Si on se place dans un autre ordre $R \pm n$, avec n différent de 1 ou 0, les courbes de réponse deviennent sinusoïdales. Les maxima successifs des courbes A et B correspondent à la mise en corrélation spatiale de l'une des images des réseaux 13 ou 14 avec le réseau 21. On verra ultérieurement comment lever l'indétermination due à la périodicité des réseaux, ce en relation avec les figs 10 à 16. Si l'on éclaire alternativement les réseaux 13 et 14 pour une position quelconque de la plaquette semi-conductrice 2 par rapport à l'image des réseaux 13 et 14 et qui correspond à une valeur quelconque de $\Delta C$, soit $\Delta C_1$, la tension de sortie des moyens opto-électroniques D varie alternativement de la valeur $V_{S13}$ à la valeur $V_{S14}$, valeurs différentes sauf pour une position particulière $\Delta C_o$ correspondant à l'alignement. La tension de sortie ne varie plus et est égale à $V_{S0}$.

Pour obtenir le résultat qui vient d'être exposé, il faut donc illuminer alternativement l'une ou l'autre des fenêtres 17 ou 18. Pour ce faire, on place au-dessus du support 1 (qui peut être opaque à la lumière en dehors des zones comprenant les réseaux 13, 14, 15 et 16 et transparent entre les traits opaques constituant ces réseaux) un modulateur optique 3, par exemple un élément électro-optique du type cellule de Pockels 3.

La cellule de Pockels 3 est illuminée sur toute sa surface par un faisceau de rayon lumineux 50, de section rectangulaire sur la fig. 1. En réalité, la section de ce faisceau 50 peut être quelconque à condition que la totalité de la surface supérieure de la cellule 3 soit illuminée. On peut placer dans ce cas un écran opaque tout autour de la cellule pour intercepter les rayons lumineux excédentaires.

La cellule 3, qui sera décrite plus en détail en relation avec la fig. 9 se comporte en réalité comme deux demi-cellules laissant passer à tour de rôle la moitié du faisceau incident sous la commande d'un signal électrique $V_e$, signal rectangulaire de haute fréquence f et dans un mode de réalisation préférée de rapport cyclique égal à 1.

Il en résulte que les fenêtres 17 et 18 sont éclairées en alternance au rythme de la variation des signaux $V_e$, les demi-cellules obturant au même rythme la partie du faisceau 50 les traversant. Sur la fig. 1, la fenêtre 18 est illuminée par le demi-faisceau 51 et la partie du réseau 14 délimitée par cette fenêtre 18 est projetée sur le réseau 21. La marche des rayons est représentée sous les références 52 et 53. Une seule direction de rayons réfractés 54 est représentée sur la fig. 1.

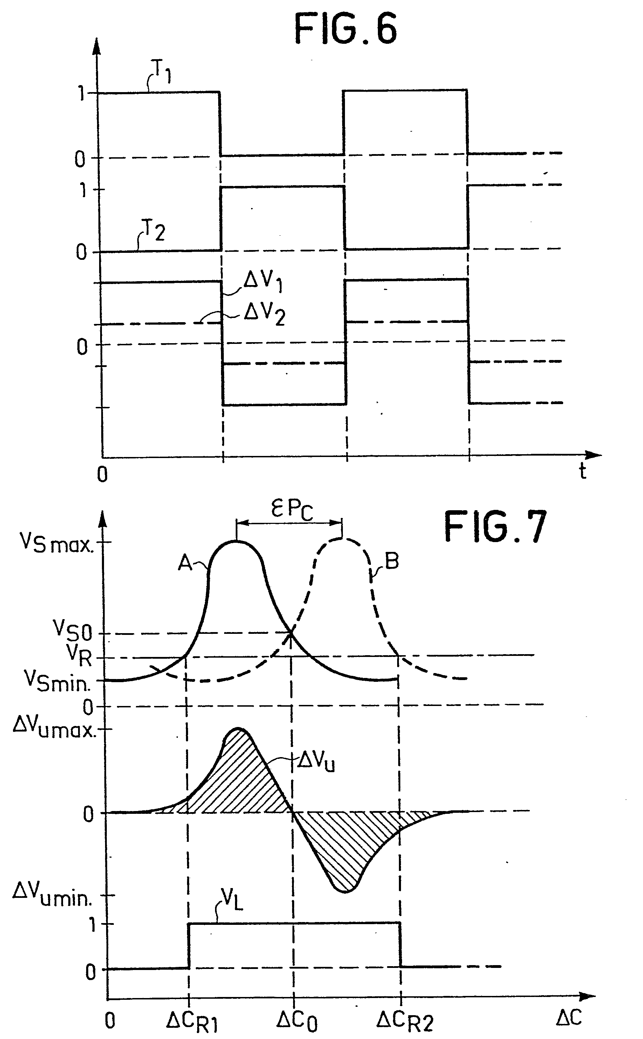

La fig. 6 illustre par les courbes $T_1$ et $T_2$ le coefficient de transmission des deux parties de la cellule 3 en fonction du temps. Ces coefficients varient sensiblement entre les valeurs «0» (pas de lumière transmise) et «1» (toute la lumière transmise), les fonctions représentées par les courbes $T_1$ et $T_2$ étant en opposition de phase. Le signal représentant la différence des tensions de sortie des moyens opto-électroniques D:

$$\Delta V = V_{S13} - V_{S14} \qquad (4)$$

est un signal alternatif dont l'amplitude s'annule lorsque l'alignement est atteint. La partie inférieure de la fig. 6 illustre deux valeurs de $\Delta V$, l'une $\Delta V_1$ loin de l'alignement et l'autre $\Delta V_2$ près de l'alignement.

L'amplitude maximale de $\Delta V$ est donnée par la relation:

$$\Delta V\, max = V_{S\,max} - V_{s\,min} \qquad (5)$$

D'autre part $\Delta V = 0$ lorsqu'on obtient l'alignement ou au contraire lorsque les images des réseaux 13 et 14 sont projetées en dehors de la zone utile du réseau 21. Un circuit logique simple, en combinaison avec les dispositifs mettant en œuvre les procédés d'approche qui seront décrits ultérieurement, permet de rejeter ce dernier cas.

En effet, ce cas correspond à l'abscisse $\Delta C_2$ sur le diagramme de la fig. 5. Pour cette abscisse $V_S = V_{S01} \neq V_{S\,min}$. Il suffit donc de disposer d'un circuit à seuil détectant une valeur de $V_S$ supérieure à un seuil prédéterminé $V_R$. Le circuit logique détecte l'apparition de $V_S \geqslant V_R$. Un simple circuit logique peut délivrer en sortie un signal binaire d'autorisation pour ouvrir le circuit d'asservissement uniquement entre deux valeurs $\Delta C_{R1}$ et $\Delta C_{R2}$ qui vont être décrites sur la fig. 7.

Si maintenant on établit la courbe $\Delta V$ relation (4), non plus en fonction du temps pour une abscisse fixe mais en fonction du désalignement $\Delta C$, on obtient une courbe $\Delta Vu$ de la partie médiane du diagramme de la fig. 7, en forme de S. Ce signal peut être élaboré à l'aide d'un détecteur synchrone de la manière qui sera explicitée dans ce qui suit en relation avec la description de la fig. 8. On a reporté sur la partie supérieure du diagramme les courbes A et B précédemment décrites et une valeur $V_R$ représentant la valeur de seuil de $V_S$ en dessous de laquelle le dispositif n'est pas autorisé à fonctionner, c'est-à-dire en dehors d'un intervalle $\Delta C_{R1} - \Delta C_{R2}$ de la courbe représentant le signal fourni par le circuit logique précité, courbe $V_L$ portée sur la partie inférieure du diagramme. Par convention la valeur «1» logique indique l'état actif du dispositif. Les caractéristiques de la courbe $\Delta Vu$ sont les suivantes:

- symétrie par rapport au couple de coordonnées $(0, \Delta C_0)$
- la valeur absolue des maxima et minima ne dépend que de la valeur $V_{S\,max} - V_{S\,min}$
- la pente de la courbe dans la région centrale ne dépend que de la valeur $\varepsilon\, P_C$, et de ce fait est déterminable. Cette partie est très proche d'une droite
- pour chaque point d'abscisse $\Delta C$ le signal $\Delta Vu$ est un signal rectangulaire variant à la fréquence f.

Il y a lieu de noter que cette dernière caractéristique autorise un tri simple des signaux destinés à la voie d'alignement suivant l'axe de référence X et ceux destinés à la voie Y. Il suffit pour ce faire d'utiliser deux fréquences distinctes, l'une $f_X$ pour la voie X et l'autre $f_Y$ pour la voie Y et de mettre en œuvre des filtres sélectifs pour discriminer les signaux X et Y.

Les signaux modulés variant en amplitude et en signe c'est-à-dire en phase selon la courbe $\Delta Vu$ sont directement utilisables par des circuits d'asservissement. La valeur absolue de $\Delta Vu$ représentant l'amplitude du désalignement $\Delta C$ et le signe le sens de ce désalignement.

Un exemple de circuit d'asservissement est illustré par la fig. 8. La plaquette semi-conductrice 2 est solidaire d'une table X, Y entraînée, comme il est bien connu, par deux servo-moteurs $M_X$, $M_Y$ suivant deux directions parallèles aux axes de référence X, Y. Seule la voie X sera décrite, la voie Y étant identique. On retrouve sur cette figure les principaux éléments déjà décrits au regard de la fig. 1 et qui ne seront plus décrits. La sortie $V_S$ du détecteur opto-électronique $D_X$ est transmise à l'entrée d'un amplificateur sélectif $A_1$. Un second détecteur $D_Y$ est prévu pour la voie Y. L'amplificateur sélectif $A_1$ est accordé sur une fréquence $f_X$. Cette fréquence est égale à la fréquence des signaux de commande produits par un générateur de signaux rectangulaires OSC. Ces signaux sont transmis, d'une part à l'entrée de commande $V_e$ de la cellule 3 et par la liaison 100 à un détecteur synchrone $D_S$, recevant sur une seconde entrée, par la liaison 101, les signaux de sortie de l'amplificateur $A_1$. Le détecteur synchrone est chargé d'élaborer les signaux $\Delta Vu$ du diagramme de la fig. 7 et de produire des signaux transmis par la liaison 102 à un amplificateur de puissance commandant par 103 le moteur $M_X$ d'entraînement de la table. Pour ce faire, les signaux $V_S$ sont comparés d'une période à l'autre du signal de commande $V_e$. La polarité des signaux ainsi élaborés doit être en accord avec la polarité des signaux $\Delta Vu$ de manière à ce que l'écart d'alignement se réduise, puisque l'on détecte la valeur $\Delta Vu = 0$. Les composants électroniques à mettre en œuvre pour réaliser des circuits d'asservissement tels que ceux de la fig. 8 sont bien connus de l'homme de métier et ne nécessitent pas une plus ample description.

La cellule opto-électronique 3 du type cellule de Pockels utilisée pour obtenir sélectivement le faisceau de rayons lumineux d'alignement est illustrée plus amplement par la fig. 9. L'élément actif en est constitué par une lame 33 de matériau cristallin présentant des effets opto-électroniques linéaires (effet Pockels). Cette lame, munie de deux électrodes 34, 35, traversée par un faisceau de rayons lumineux polarisés et transparente à ces rayons, fait tourner la polarisation de ces rayons de $\pi/2$ selon la tension $V_e$ appliquée aux bornes des électrodes. Dans le cadre de l'invention, la tension appliquée $V_e$, délivrée par le générateur OSC (fig. 8), se présente sous la forme de signaux rectangulaires de fréquence élevée. A titre d'exemple non limitatif, la fréquence peut être comprise dans la gamme 100 KHz à 1 MHz. Le matériau utilisé peut être du KDP. D'autres matériaux (ADP, niobate de lithium, niobate de baryum sodium, etc...) présentent également des effets électro-optiques linéaires. Ces matériaux doivent être transparents ou de faible absorption pour la longueur d'onde de la lumière utilisée. Le cristal électro-optique 33 est précédé d'un polariseur 31 si la lumière n'est pas déjà polarisée et suivi d'un analyseur 32. D'autre part, une lame demi-onde 36 est disposée sur la moitié de la surface du cristal électro-optique 33, définissant ainsi une demi-cellule. L'axe neutre 136 de cette lame forme un angle de $\pi/4$ avec les axes de polarisation croisée 131 et 132, respectivement du polariseur 31 et de l'analyseur 32. On suppose, pour fixer les idées, que l'axe de polarisation 131 est parallèle à l'axe de référence Y. On a fait figurer sur la fig. 9 pour illustrer le fonctionnement deux minces pinceaux 38 et 39 de lumière non polarisée traversant chacun une des demi-cellules ainsi définie. Seul le pinceau 38 va émerger de l'analyseur 32 avec une polarisation parallèle à l'axe Y, la tension $V_e$ étant telle que le cristal opto-électronique 33 fasse tourner l'axe de polarisation du faisceau émergeant de la lame demi-onde 36. Cette lame demi-onde 36 a pour sa part fait tourner la polarisation de $\pi/2$ ($2 \times \pi/4$). Dans la réalité, comme on l'a vu précédemment, les pinceaux 38 et 39 sont confondus en un seul faisceau de section suffisante pour recouvrir entièrement la surface de la cellule. Il s'en suit que seul un demi-faisceau émerge au rythme des variations du signal $V_e$ appliqué aux bornes des électrodes 34 et 35, alternativement en 232 et en 233, illuminant de ce fait l'une ou l'autre des fenêtres 17 ou 18 (fig. 1). Pour ne pas altérer la symétrie de la cellule 3, une lame, soit neutre, soit demi-onde, mais dont l'axe neutre est parallèle à l'axe de polarisation du polariseur 31, peut être introduite en 37. Les chemins optiques des deux demi-cellules sont alors égaux.

Dans l'exemple illustré sur la fig. 9, l'effet transversal est utilisé. Cela nécessite que les électrodes 34 et 35 soient transparentes. On peut également utiliser l'effet longitudinal. Enfin tout en mettant en œuvre l'effet Pockels, on peut remplacer la cellule ainsi décrite par un déviateur commutant le faisceau incident entre deux zones de faisceau émergeant.

On peut également utiliser d'autres effets électro-optiques tels que des effets quadratiques du type présenté par les cellules de Kerr, ou encore utiliser des cellules à cristaux liquides du type nématique en hélice faisant tourner la polarisation sous l'effet d'une tension de commande. Dans ce dernier cas la fréquence de la tension de commande ne peut atteindre les valeurs permises par les effets Pockels ou Kerr. Tous ces effets sont bien connus et ne nécessitent pas une plus ample description. On peut également utiliser des cellules acousto-optiques.

Si on revient aux figs 1 et 2, selon un aspect intéressant de l'invention, la cellule 3 ainsi constituée est solidaire d'un équipage mobile (non représenté) se déplaçant suivant une direction $Y_2$ parallèle à l'axe Y; (une seconde cellule non représentée se déplaçant suivant une direction $X_2$ parallèle à l'axe X). Une flèche portée sur les figs 1 et 2 symbolise le déplacement. Il s'en suit que les fenêtres 17 et 18 se déplacent également suivant une direction $Y_1$ parallèle à l'axe Y. Ceci permet d'adapter le dispositif d'alignement de l'invention à la taille des circuits présents sur la plaquette semi-conductrice, et en particulier à la position des réseaux 21 et 22 par rapport à l'axe $Z_1$.

Pour que la source utilisée pour l'alignement s'image toujours au même point O, ce point O devant être situé au centre de la pupille de l'objectif de projection, selon un autre aspect avantageux de l'invention, on insère entre la cellule 3 et le support 1 portant les réseaux 13–14 et 15–16 un condenseur 4. Ce dispositif est illustré plus particulièrement par la fig. 2.

La source 5 produisant le faisceau d'alignement est une source d'énergie radiante, par exemple un laser He Ne de longueur d'onde $\lambda = 632,8$ nm. Le faisceau est constitué de rayons 50 parallèles à l'axe Y qui peuvent être réfléchis par un miroir m vers la cellule 3. Ces rayons traversent la cellule 3 et le condenseur 4, ressortent en 51 et sont projetés sur l'une des fenêtres (17 par exemple), puis à leur sortie en 52 convergent en O sur l'axe $Z_1$, ce quelle que soit la position de la cellule 3. On a représenté la cellule 3 en une autre position 3'. On retrouve les mêmes éléments pour cette position: m', 51', 17', 52'. Le miroir mobile m doit donc être solidaire de l'équipage mobile entraînant la cellule 3. Le positionnement suivant l'axe $Y_2$ n'est pas critique pour l'alignement car les réseaux 13 et 14 s'étendent sur toute la longueur du support 1. En ce qui concerne le positionnement suivant l'axe $X_2$, une précision de l'ordre de 0,1 mm est suffisante. En effet, il suffit, comme illustré par la fig. 3, que la ligne de séparation 19 des fenêtres 17 et 18 se projette entre les deux réseaux 13 et 14. La tolérance est donc de l'ordre de la distance $d_X$ séparant ces deux réseaux. Suivant l'axe $X_1$, parallèle à X, les largeurs effectives des fenêtres 17 et 18 sont définies par les largeurs $1_{13}$ et $1_{14}$ des réseaux qui peuvent être définies avec une grande précision lors de l'élaboration du support 1. D'autre part ce support, dans l'exemple choisi, est fixe par rapport au châssis du photo-répéteur.

Comme il a été précédemment indiqué, les réseaux mis en œuvre dans l'invention sont du type périodique. Ils ont d'ailleurs l'avantage sur d'autres types de réseaux, par exemple les réseaux à pas variables selon un code pseudo-aléatoire, de présenter une meilleure dynamique de réponse. Les réponses de ces deux types de réseaux sont comparées dans la demande de brevet français N° 7 905 007 précitée. Pour un réseau de type périodique la valeur $V_{S\,min}$ (fig. 5) est très faible, c'est-à-dire que le bruit de fond est très faible, tandis que pour les réseaux à pas variable selon un code pseudo-aléatoire $V_{S\,min}$ est de l'ordre de 20 à 50% de $V_{S\,max}$. Pour ces réseaux il faut cependant lever l'indétermination due à la périodicité en procédant à une phase initiale d'alignement qui sera appelée dans ce qui suit pré-alignement.

Un premier procédé, également décrit dans la demande précitée, est rappelé en regard des figs 10 et 11. Pour lever l'indétermination, on va placer deux réseaux auxiliaires 210 et 211 (également à pas constant, mais différents l'un de l'autre: $P_{R1}$ et $P_{R2}$ et différents du pas $P_R$ du réseau principal 21) de part et d'autre du réseau 21, suivant la direction C. Hors alignement, un de ces réseaux va diffracter également dans la direction R, selon que les images des réseaux 13–14 sont projetées sur le réseau 21 trop à droite ou trop à gauche, suivant la direction C. Sur la fig. 11, en plus de l'ordre de diffraction $R_1$ du réseau principal 21, on trouve les ordres des réseaux 210 et 211: $R'_1$ et $R''_1$, ces deux derniers ordres étant exclusifs l'un de l'autre. Dans l'exemple choisi la relation $P_{R2} > P_R > P_{R1}$ est supposée satisfaite. Si on place, suivant la direction R, trois détecteurs $D''$, D et $D'$, l'alignement se fait en deux phases: pendant la première phase ou pré-alignement, l'un des deux ordres $R'_1$ ou $R''_1$ est détecté, on détermine ainsi la direction du non alignement et on agit sur les organes commandant le déplacement de la plaquette; pendant la seconde phase ou alignement fin seule l'intensité de l'ordre $R_1$ du réseau principal est mesurée. Comme précédemment, l'ordre $R_{-1}$ peut également être détecté ou tout ordre $R_{\pm n}$ différent de l'ordre $R_0$.

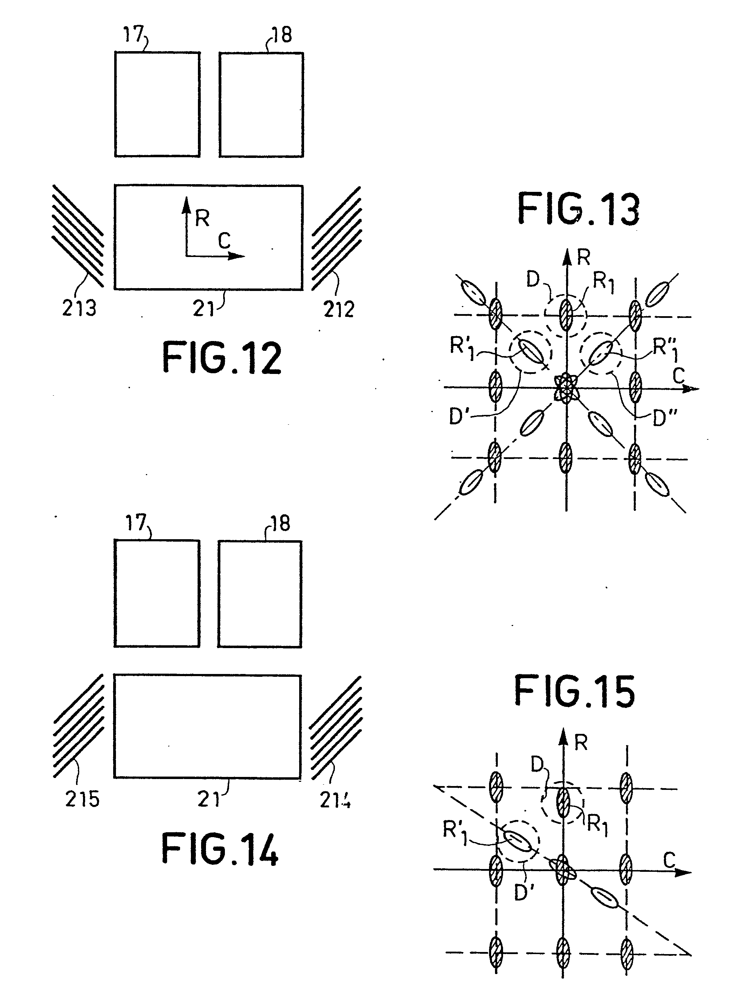

Un second procédé est illustré par les figs 12 et 13. On grave de part et d'autre des réseaux 21 et 22 portés par la plaquette semi-conductrice 2, par exemple le réseau 21, deux réseaux auxiliaires 212 et 213 constitués de traits formant un certain angle avec la direction C. Dans une réalisation préférée, pour le réseau 212, cet angle est de $\pi/4$ et pour le réseau 213 de $3\,\pi/4$. Il s'en suit trois figures différentes de diffraction dans le plan de Fourier $P_F$, suivant trois directions privilégiées formant entre elles les mêmes angles $\pi/4$, $3\,\pi/4$ ou si on se place par rapport à la direction R: $\pm\,\pi/4$. On peut détecter les ordres $R_1$, $R'_1$ et $R''_1$ à l'aide de trois détecteurs D, $D'$ et $D''$, comme pour le premier procédé.

Une variante de ce procédé est illustrée par les figs 14 à 16. Des réseaux auxiliaires de même

inclinaison (par exemple $+\pi/4$) sont placés de part et d'autre du réseau 21. Selon cette variante, autorisée par la présente invention, un seul détecteur D′ détectant par exemple l'ordre R′$_1$, est nécessaire. la discrimination, nécessaire pour déterminer le sens du désalignement, est rendue possible par la détection de la phase du signal de sortie V′ du détecteur D′ par rapport à la phase du signal V$_e$ de commande de la cellule électrooptique 3, comme illustré par la fig. 16. V$_e$ et V′ sont en phase ou en opposition de phase, selon le sens du décalage relatif de l'image des réseaux 13 et 14 sur le réseau 21.

Bien que l'invention ait été décrite dans le cadre particulier d'un photo-répéteur, pour le positionnement précis d'un réticule par rapport à une plaquette semi-conductrice portant chacun des motifs servant à l'alignement, ce par un procédé mettant en œuvre un motif d'alignement intermédiaire, l'invention n'est nullement limitée à cet exemple de réalisation. L'invention s'applique à tout positionnement automatique précis, l'un par rapport à l'autre, de deux objets sur lesquels sont portés des motifs d'alignement dont l'un formant référence doit, selon l'invention, être constitué d'au moins un couple de deux réseaux optiques identiques et éclairés en alternance.

A la lumière de la description qui précède, on peut résumer les principaux avantages de l'invention comme suit:

— modulation à fréquence élevée, par des moyens électroniques et électro-optiques, des signaux utilisés pour l'asservissement (c'est-à-dire avec une faible inertie);

— détermination précise de la référence de repos («zéro mécanique»);

— filtrage efficace des signaux électriques rendu possible par la fréquence élevée de modulation;

— pas d'introduction d'éléments optiques ou électro-optiques dans l'intervalle séparant les deux motifs d'alignement (autres que l'objectif de projection et des lentilles de correction non représentés, dans le cadre de la photorépétition);

— adaptation aisée du dispositif à des dimensions et positions relatives variables de deux motifs d'alignement, ce sans entraîner des contraintes importantes quant au positionnement du motif de référence;

— optimisation également aisée du signal $\Delta Vu$ utilisé pour l'asservissement, ce en agissant simplement sur les valeurs $\varepsilon$ et $P_c$ (fig. 7).

**Revendications**

1. Système d'alignement optique d'au moins un premier motif porté par un support mobile (2) par rapport à un second motif porté par un support fixe (1), formant référence; les premier et second motifs comprenant chacun au moins un repère d'alignement du type constitué par au moins un réseau optique (21, 13–14) à pas constant (Pc, P), le système comprenant en outre des moyens optiques (O$_P$) de grandissement (G) déterminé destinés à projeter l'image du réseau (13–14) formant le repère d'alignement du second motif sur le réseau (21) formant le repère d'alignement du premier motif, cette projection produisant des ordres de diffraction dont l'intensité lumineuse est représentative de l'état d'alignement atteint, ainsi que des moyens opto-électroniques (D) pour détecter l'intensité lumineuse de l'un des ordres de diffraction, différent de zéro, ainsi produits; système caractérisé en ce que le repère d'alignement du second motif comprend au moins un couple de deux réseaux optiques identiques (13–14), constitués chacun par une suite de traits parallèles à un premier axe de symétrie (Y$_1$) et situés de part et d'autre de cet axe, en étant séparés l'un de l'autre d'une distance prédéterminée (d$_X$), cette distance (d$_X$) étant choisie de façon à être différente d'un multiple entier du pas commun (P) aux deux réseaux dudit couple (13–14), et l'extension transversale totale (21 + d$_X$) dudit couple étant par ailleurs choisie relativement à celle (l 21) dudit réseau correspondant porté par le support mobile (2) et au grandissement (G) des moyens de projection (O$_P$), de façon que l'image dudit couple de réseaux dans le sens transversal soit superposable par projection dans sa totalité sur ledit réseau correspondant (21), et en ce que deux fenêtres (17–18) délimitent deux portions, respectivement des premier et second réseaux optiques (13–14), ledit système comportant en outre des moyens optiques comprenant une source d'énergie lumineuse (5) produisant un faisceau d'alignement (50) chargé d'illuminer lesdites fenêtres et un commutateur sélectif (3) disposé sur le trajet dudit faisceau d'alignement (50) et recevant un signal de commande (V$_e$) de fréquence déterminée pour illuminer alternativement à cette fréquence l'une et l'autre fenêtre, et assurer ainsi la projection en alternance, sur ledit réseau correspondant (21) porté par le support mobile (2), de l'image de l'une et l'autre portion desdits premier et second réseaux (13–14) délimitées par lesdites fenêtres (17–18), ladite projection alternée entraînant ainsi l'élaboration en sortie des moyens opto-électroniques (D) d'un signal (Vs) dont le niveau (Vs 13, Vs 14) normalement diffère d'une alternance à l'autre du signal de commande (Ve), et ledit signal de sortie (Vs 13, V 14) étant en outre transmis à des moyens électroniques de comparaison (Ds) établissant ladite différence de niveau (Vs 13–Vs 14) de ce dernier d'une alternance à l'autre, l'alignement étant alors obtenu lorsque ladite différence de niveau devient nulle d'une alternance à l'autre.

2. Système selon la revendication 1, caractérisé en ce que le commutateur sélectif (3) des moyens optiques est constitué par un modulateur optique disposé sur le trajet du faisceau d'alignement.

3. Système selon la revendication 2, caractérisé en ce que le modulateur optique est une cellule acousto-optique.

4. Système selon la revendication 2, caractérisé en ce que le modulateur optique est constitué par une cellule électro-optique disposée sur le trajet du faisceau d'alignement et comprenant des moyens polariseurs d'entrée (31), une lame de cristal (33) ayant des propriétés électro-optiques munie de deux électrodes de commande (34, 35) recevant un signal de commande rectangulaire (V$_e$) de fréquence élevée et destiné à faire tourner cycliquement de $\pi/2$ la polarisation du faisceau émergeant et des moyens analyseurs de sortie (32) d'axe de polarisation (132) orthogonaux à l'axe de polarisation (131) des moyens polariseurs; une lame demi-onde (36) étant en outre disposée sur la face d'entrée de la lame de cristal ayant des propriétés électro-optiques (33), les dimensions de la lame demi-onde (36) étant telles qu'elle recouvre à moitié la lame de cristal créant ainsi deux demi-cellules divisant le faisceau d'alignement en deux parties égales, l'une seulement de ces deux parties étant transmise à chaque instant, en alternance d'une période à l'autre du signal de commande (V$_e$) pour illuminer cycliquement les deux fenêtres (17, 18).

5. Système selon la revendication 4, caractérisé en ce que la lame de cristal présente un effet électro-optique linéaire dit de Pockels.

6. Système selon l'une quelconque des revendications 4 ou 5, caractérisé en ce que le modulateur (3) est solidaire d'un équipage mobile selon une direction (Y$_2$) parallèle au premier axe de symétrie (Y$_1$) rendant possible le déplacement des fenêtres (17, 18) le long de cet axe et en ce qu'un miroir (m) solidaire de cet équipage mobile réfléchit le faisceau d'alignement vers le modulateur; le faisceau étant produit par une source cohérente d'énergie radiante suivant une direction parallèle au premier axe de symétrie (Y$_1$) et des moyens optiques (4) étant disposés entre le modulateur et le support fixe (1) pour former l'image de la source laser au centre (0) de la pupille d'entrée des moyens optiques à grandissement déterminé.

7. Système selon l'une quelconque des revendications 1 à 6, caractérisé en ce que les traits formant le réseau correspondant (21) porté par le support mobile (2) sur lequel sont projetés en alternance l'image des premier et second réseaux (13, 14), étant en outre interrompus périodiquement suivant une seconde direction (R) pour former également un réseau à pas constant (P$_R$) suivant cette direction, les moyens opto-électroniques détectent un des ordres de diffraction (R$_1$) différent de l'ordre zéro suivant cette direction.

8. Système selon l'une quelconque des revendications 1 à 7, caractérisé en ce que les repères d'alignement du second motif comprennent des troisième et quatrième réseaux optiques identiques (15, 16), constitués chacun par une suite de traits parallèles à un second axe de symétrie (X$_1$) et de part et d'autre de cet axe, les deux réseaux étant distants l'un de l'autre d'une longueur prédéterminée; et en ce qu'il est prévu en outre des moyens optiques supplémentaires comprenant une source cohérente d'énergie radiante et un commutateur sélectif pour illuminer alternativement des portions des troisième et quatrième réseaux délimitées par des fenêtres.

9. Système selon l'une quelconque des revendications 1 à 8, caractérisé en ce qu'en outre des premier et second réseaux auxiliaires à pas constant sont disposés de part et d'autre du réseau correspondant (21) porté par le support mobile (2) et permettent un pré-alignement en levant l'indétermination due à la périodicité des réseaux.

10. Système selon la revendication 9, caractérisé en ce que le premier (210) des réseaux auxiliaires est constitué par une première suite de traits parallèles équidistants d'un premier pas constant (P$_{R1}$) suivant la seconde direction (R) et le second (211) des réseaux auxiliaires est constitué par une seconde suite de traits parallèles équidistants d'un second pas constant (P$_{R2}$) suivant la seconde direction (R), et en ce que des premier (D') et second (D'') moyens opto-électroniques supplémentaires détectent un des ordres de diffraction (R'$_1$, R''$_1$) différent de l'ordre zéro suivant la seconde direction (R) produits par les premier et second réseaux auxiliaires.

11. Système selon la revendication 9, caractérisé en ce que les premier (212) et second (213) réseaux auxiliaires sont constitués chacun par une suite de traits équidistants et parallèles respectivement à une troisième et quatrième directions formant un angle déterminé avec la première direction (C), différent de zéro et de $\pi/2$; et en ce que des premier (D') et second (D'') moyens opto-électroniques supplémentaires détectent un des ordres de diffraction (R'$_1$, R''$_1$) différent de l'ordre zéro suivant les troisième et quatrième directions produits par les premier et second réseaux auxiliaires.

12. Système selon la revendication 9, caractérisé en ce que les premier (214) et second (215) réseaux auxiliaires sont identiques et constitués chacun par une suite de traits équidistants parallèles à une troisième direction formant un angle déterminé avec la première direction (C), différent de zéro et de $\pi/2$; et en ce que des moyens opto-électroniques supplémentaires (D') détectent un des ordres de diffraction (R'$_1$) produits par les premier et second réseaux auxiliaires et différent de l'ordre zéro suivant la troisième direction; le sens du désalignement étant déterminé par comparaison des phases relatives des signaux de commande (V$_e$) et des signaux de sortie des moyens opto-électroniques supplémentaires (D').

**Claims**

1. Optical alignment system of at least a first pattern borne by a support (2) mobile with respect to a second pattern borne by a fixed support (1), forming a reference; the first and the second patterns each comprising at least one alignment reference of the type constituted by at least one optical grid (21, 13–14) at regular pitch (Pc, P), the system comprising furthermore optical means (O$_P$) of determined magnification (G) destined to project the image of the grid (13–14) forming the alignment reference of the second pattern on the grid (21) forming the alignment reference of the first pattern, this projection producing diffraction orders of which the luminous intensity is representative of the state of alignment reached, as well as optoelectrical means (D) to detect the luminous intensity of one of the diffraction orders, different from zero, thus produced: system characterized in that the alignment reference of the second pattern comprises at least a couple of two identical optical grids (13–14), each constituted by a continuation of lines parallel to a first axis of symmetry ($Y_1$) and situated on either side of this axis, while being separated from each other by a predetermined distance ($d_X$), this distance ($d_X$) being selected in such a way as to be different by a multiple integer from the pitch (P) common to the two grids of the said couple (13–14), and the total transversal extension ($21 + d_X$) of the said couple being furthermore selected relatively to that (P 27) of the said corresponding grid borne by the mobile support (2) and to the magnification (G) of the projection means ($O_P$), in such a way that the image of the said couple of grids in the transversal direction is in its totality superimposable by projection on the said corresponding grid (21), and in that the two windows (17–18) delimit two parts, respectively from the first and second optical grids (13–14), the said system comprising furthermore optical means containing a light energy source (5) producing an alignment beam (50) to illuminate the said windows and a selective change-over switch (3) disposed on the path of the said alignment beam (50) and receiving a control signal ($V_e$) of frequency determined to illuminate alternately at this frequency one and the other windows, and to thus ensure the projection in alteration, on the said corresponding grid (21) borne by the mobile support (2), of the image of one and the other positions of the said first and second grids (13–14) delimited by the said windows (17–18), the said alternated projection thus provoking the elaboration at the exit of optoelectrical means (D) of a signal (Vs) the level of which (Vs 13, Vs 14) normally differs by one alternation to the other of the control signal (Ve), and the said output signal (Vs 13, V 14) being furthermore transmitted to electronic comparison means (Ds) establishing the said difference of level (Vs 13–Vs 14) from the latter of one alternation to another, the alignment being thus obtained when the said difference of level becomes nil from one alternation to the other.

2. System according to claim 1, characterized in that the selective change-over switch (3) of the optical means is constituted by an optical modulator disposed on the path of the alignment beam.

3. System according to claim 2, characterized in that the optical modulator is an acoustic-optical cell.

4. System according to claim 9, characterized in that the optical modulator is constituted by an optoelectrical cell disposed on the path of the alignment beam and comprising input polarizer means (31), a crystal blade (33) having optoelectrical properties provided with two control electrodes (34, 35) receiving a high frequency rectangular control signal ($V_e$) destined to cause to turn

cyclically by $\pi/2$ the polarization of the emerging bearm and output analyzing means (32) of the polarization axis (132) orthogonal to the polarization axis (131) of the polarizing means; a half-wave blade (36) being, furthermore, disposed on the input face of the crystal blade having optoelectrical properties (33), the dimensions of the half-wave blade (36) being such that they cover half the crystal blade thus forming two half-cells dividing the alignment beam into two equal parts, only one of the two parts being transmitted at each instant, in alternation from one period to the other of the control signal ($V_e$) to illuminate cyclically the two windows (17, 18).

5. System according to claim 4, characterized in that the crystal blade presents a linear optoelectrical effect called Pockels.

6. System according to either of claims 4 or 5, characterized in that the modulator (3) is integral of a moving contact along a direction ($Y_2$) parallel to the first axis of symmetry ($Y_1$) rendering possible the displacement of the windows (17, 18), the length of this axis and in that a mirror (m) integral of this moving contact reflects the alignment beam towards the modulator; the beam being produced by a radiating energy source along a direction parallel to the axis of symmetry ($Y_1$) and optical means (4) being disposed between the modulator and the fixed support (1) to form the image of the laser source at the centre (10) of the input pupil of the optical means at determined enlargements.

7. System according to any one of claims 1 to 6, characterized in that the lines forming the corresponding grid (21) borne by the mobile support (2) on which are projected in alternation the image of the first and second grids (13, 14) being furthermore interrupted periodically along a second direction (R) also to form a grid at regular pitch ($P_R$) along this direction, the optoelectric means detect one of the different orders of diffraction ($R_1$) differing from the zero order along this direction.

8. System according to one of claims 1 to 7, characterized in that the alignment references of the second pattern comprise the third and fourth identical optical grids (15, 16) each constituted by a continuation of lines parallel to a second axis of symmetry ($X_1$) and on either side of this axis, the two grids being distant from each other by a predetermined length; and in that it is provided furthermore with supplementary optical means comprising a coherent radiating energy source and a selective switch-over means for alternately selecting parts of the third and fourth grids delimited by the windows.

9. System according to any one of claims 1 to 8, characterized in that furthermore the first and second auxiliary grids with regular pitch are disposed on either side of the corresponding grid (21) borne by the mobile support (2) and allowing a prealignment by raising the indetermination due to the periodicity of the grids.

10. System according to claim 9, characterized in that the first (210) of the auxiliary grids is constituted by a first continuation of parallel lines equidistant from a first constant pitch ($P_{R1}$) along the second direction (R) and the second (211) of the auxiliary grids is constituted by a second continuation of parallel lines equidistant from a second constant pitch ($P_{R2}$) along the second direction (R), and in that the first (D') and the second (D'') supplementary optoelectrical means detecting one of the diffraction orders ($R'_1$, $R''_1$) differs from the zero order along the second direction (R) produced by the first and second auxiliary means.

11. System according to claim 9, characterized in that the first (212) and second (213) auxiliary grids are each constituted by a continuation of equidistant lines and parallel respectively to a third and fourth direction forming an angle determined with the first direction (C), differing from zero and $\pi/2$; and in that the first (D') and second (D'') supplementary optoelectric means detect one of the orders of diffraction ($R'_1$, $R''_1$), differing from the zero order along the third and fourth directions produced by the first and second auxiliary grids.

12. System according to claim 9, characterized in that the first (214) and second (215) auxiliary grids are identical and each constituted by a continuation of equidistant lines parallel to a third direction forming an angle determined with the first direction (C), differing from zero and $\pi/2$; and in that the supplementary optoelectronic means (D') detect one of the orders of diffraction ($R'_1$) produced by the first and second auxiliary grids and differing from zero order along the third direction; the sense of the disalignment being determined by comparison of the relative phases of the control signals ($V_e$) and output signals of the supplementary optoelectronic means (D').

**Patentansprüche**

1. System zum optischen Ausrichten wenigstens eines ersten, von einem beweglichen Träger (2) getragenen Motivs in bezug auf ein von einem ortsfesten Träger (1) getragenes und ein Bezugsmotiv bildendes zweites Motiv, wobei diese beiden Motive je wenigstens ein durch wenigstens ein optisches Netz (21, 13–14) mit konstantem Raster (Pc, P) gebildetes Ausrichtmerkzeichen besitzen, und das System ferner optische Mittel ($O_P$) für die vorbestimmte Vergrösserung (G) aufweist, die dazu bestimmt sind, das Bild des das Ausrichtmerkmal des zweiten Motiv bildenden Netzes (13–14) auf das das Ausrichtmerkmal des ersten Motivs bildende Netz (21) zu projizieren, derart, dass diese Projektion Diffraktionsgrade erzeugt, deren Lichtstärke den Grad der jeweils erzielten Ausrichtung darstellt, während ferner optischelektronische Mittel (D) vorgesehen sind, die die Lichtstärke eines der somit erzeugten, von Null verschiedenen Diffraktionsgrade ermitteln, dadurch gekennzeichnet, dass das Ausrichtmerkzeichen des zweiten Motivs wenigstens ein Paar identische optische Netze (13–14) aufweist, deren jedes aus einer Folge von zu einer ersten Symmetrieachse ($Y_1$) parallelen, beiderseits dieser Achse angeordneten Linien besteht, die voneinander um einen vorbestimmten Abstand ($d_X$) getrennt sind, welcher derart gewählt ist, dass er von einem ganzzahligen Vielfachen des gemeinsamen Rasters (P) der beiden Netze dieses Netzpaares (13–14) verschieden ist, wobei die Gesamtausdehnung ($21 + d_X$) dieses Netzpaares in bezug auf die Ausdehnung ($1_{21}$) des genannten entsprechenden, vom beweglichen Träger (2) getragenen Netzes und in bezug auf die Vergrösserung (G) der Projektionsmittel ($O_P$) derart gewählt ist, dass das Bild des Netzpaares in Querrichtung in seiner Gesamtheit auf das entsprechende Netz (21) projizierbar ist, und ferner dadurch gekennzeichnet, dass zwei Fenster (17–18) je einen Abschnitt des ersten und des zweiten optischen Netzes (13–14) begrenzen, wobei das System ferner optische Mittel besitzt, die eine ein Ausrichtbündel (50) erzeugende die beiden Fenster erleuchtende Lichtenergiequelle (5) umfassen, Strahlweg des Ausrichtbündel angeordneten Wahlschalters (3), der ein Steuersignal ($V_c$) bestimmter Frequenz empfängt, um die beiden Fenster abwechselnd zu beleuchten und somit zu bewirken, dass das Bild der beiden durch die Fenster (17–18) begrenzten Abschnitte des ersten und zweiten Netzes (13–14) abwechselnd auf das vom beweglichen Träger (2) getragene, entsprechende Netz (21) projiziert wird, so dass diese Projektion am Ausgang der optisch-elektronischen Mittel (D) ein Signal (Vs) erzeugt, dessen Amplitude (Vs 13, Vs 14) normalerweise jeweils von einer Wechselperiode zur anderen vom Steuersignal (Ve) verschieden ist, während das Ausgangssignal (Vs 13, Vs 14) ferner an elektronische Vergleichsmittel (Ds) übertragen wird, die die Amplitudendifferenz (Vs 13–Vs 14) des letzteren von einer Wechselperiode zur anderen ermitteln, derart, dass die Ausrichtung dann erzielt ist, wenn diese Amplitudendifferenz von einer Wechselperiode zur anderen gleich null wird.

2. System nach Anspruch 1, dadurch gekennzeichnet, dass der Wahlschalter (3) der optischen Mittel aus einem auf dem Strahlweg des Ausrichtbündels angebrachten optischen Modulator besteht.

3. System nach Anspruch 2, dadurch gekennzeichnet, dass der optische Modulator eine akustisch-optische Zelle ist.

4. System nach Anspruch 2, dadurch gekennzeichnet, dass der optische Modulator aus einer elektro-optischen Zelle besteht, die auf dem Strahlweg des Ausrichtbündels angebracht ist und polarisierende Eingangsmittel (31) sowie ein elektro-optische Eigenschaften besitzendes, mit zwei ein rechteckiges Hochfrequenzsteuersignal (Ne) empfangenden Steuerelektroden (34, 35) versehenes Kristallplättchen (33) umfasst, welches Steuersignal dazu dient, die Polarisation des austretenden Bündels zyklisch um $\pi/2$ zu drehen, ferner Ausgangsanalysiermittel (32) mit einer zu der Polarisationsachse (131) der Polarisationsmittel orthogonalen Polarisationsachse (132), wobei ein Halbwellenplättchen (36) auf der Eingangseite des elektro-optische Eigenschaften (33) besitzenden Kristallplättchens angebracht ist, und derartige Abmessungen besitzt, dass es zur Hälfte das Kristallplättchen bedeckt und somit zwei Halbzellen definiert, welche das Ausrichtbündel in zwei gleiche Teile teilen, von denen nur einer zu jedem Zeitpunkt übertragen wird, und zwar abwechselnd von einer Periode zur anderen des Steuersignals (Ve) um die zwei Fenster (17, 18) zyklisch zu beleuchten.

5. System nach Anspruch 4, dadurch gekennzeichnet, dass das Kristallplättchen einen linearen elektro-optischen sogenannten Pockel-Effekt aufweist.

6. System nach einem der Ansprüche 4 oder 5, dadurch gekennzeichnet, dass der Modulator (3) mit einer Baugruppe fest verbunden ist, die in einer zur ersten Symmetrieachse ($Y_1$) parallelen Richtung ($Y_2$) beweglich ist, was das Versetzen der Fenster (17, 18) längs dieser Achse ermöglicht und dadurch, dass ein mit dieser beweglichen Baugruppe fest verbundener Spiegel (m) das Ausrichtbündel in Richtung des Modulators spiegelt, wobei das Bündel von einer kompakten strahlenden Strahlungsenergiequelle in einer zur ersten Symmetrieachse ($Y_1$) parallelen Richtung erzeugt wird und wobei optische Mittel (4) zwischen dem Modulator und dem ortsfesten Träger (1) angebracht sind, um das Bild der Laserquelle im Zentrum (0) der Eingangspupille der eine vorbestimmte Vergrösserung bewirkenden optischen Mittel zu bilden.

7. System nach einem der Ansprüche 1 bis 6, dadurch gekennzeichnet, dass die Linien, die das entsprechende vom beweglichen Träger (2) getragene Netz (21) bilden, auf welchen Träger abwechselnd das Bild des ersten und zweiten Netzes (13, 14) projiziert wird, ferner periodisch in einer zweiten Richtung (R) unterbrochen werden, um ebenfalls ein Netz mit konstantem Raster ($P_R$) in dieser Richtung zu bilden, wobei die elektrooptischen Mittel einen der in dieser Richtung vom Nullgrad abweichenden Diffraktionsgrad ($R_1$) ermitteln.

8. System nach einem der Ansprüche 1 bis 7, dadurch gekennzeichnet, dass die Ausrichtbezugsmerkzeichen des zweiten Motivs dritte und vierte identische optische Netze (15, 16) umfassen, von denen jedes aus einer Folge von zu einer zweiten Symmetrieachse ($X_1$) parallelen und beiderseits dieser Achse befindlichen Strichen besteht, wobei die beiden Netze voneinander einen vorbestimmten Abstand haben, und dadurch, dass ferner zusätzliche optische Mittel vorgesehen sind, die eine kompakte Strahlungs-Energiequelle und einen Wahlschalter zur abwechselnden Beleuchtung des durch die Fenster begrenzten dritten und vierten Netzes umfassen.

9. System nach einem der Ansprüche 1 bis 8, dadurch gekennzeichnet, dass ferner erste und zweite Hilfsnetze mit konstantem Rasterabstand beiderseits des entsprechenden von dem beweglichen Träger (2) getragenen Netzes (21) angebracht sind und durch Aufhebung der durch die periodische Natur der Netze bedingten Unbestimmtheit eine Vor-Ausrichtung gestatten.

10. System nach Anspruch 9, dadurch gekennzeichnet, dass das erste Hilfsnetz (210) aus einer ersten Reihe von parallelen Linien mit einem einem ersten konstanten Rasterabstand ($P_{R1}$) in der zweiten Richtung entsprechenden gleichförmigen Abstand gebildet ist und das zweite Hilfsnetz (211) von einer zweiten Reihe von parallelen Linien mit einem in der zweiten Richtung (R) konstanten zweiten Rasterabstand ($P_{R2}$) entsprechenden gleichförmigen Abstand gebildet ist; und dass erste (D') und zweite (D'') zusätzliche elektrooptische Mittel einen der vom ersten und zweiten Hilfsnetz erzeugten Diffraktionsgrade ($R'_1$, $R''_1$) ermitteln, der in der zweiten Richtung (R) vom Nullgrad verschieden ist.

11. System nach Anspruch 9, dadurch gekennzeichnet, dass das erste und zweite Hilfsnetz (212 bzw. 213) aus je einer Reihe von Linien mit gleichförmigem Abstand besteht, die zu einer dritten bzw. vierten Richtung parallel verlaufen und mit der ersten Richtung (C) einen von Null und $\pi/2$ verschiedenen Winkel bilden; und dass erste (D') und zweite (D'') zusätzliche elektro-optische Mittel einen der vom ersten und zweiten Hilfsnetz erzeugten Diffraktionsgrade ($R'_1$, $R''_1$) ermitteln, der in der dritten und vierten Richtung vom Nullgrad verschieden ist.

12. System nach Anspruch 9, dadurch gekennzeichnet, dass das erste Hilfsnetz (214) und das zweite Hilfsnetz (215) identisch sind und aus je einer Reihe von Linien mit gleichförmigem Abstand bestehen, die zu einer dritten Richtung parallel verlaufen, welche mit der ersten Richtung (C) einen von Null und $\pi/2$ verschiedenen Winkel bildet; und dass zusätzliche elektro-optische Mittel (D') einen der vom ersten und zweiten Hilfsnetz erzeugten Diffraktionsgrade ($R'_1$) ermitteln, der in der dritten Richtung vom Nullgrad verschieden ist; wobei die Richtung der Nichtausrichtung durch Vergleichen der Phasen der Steuersignale ($V_e$) mit denjenigen der Ausgangssignale der zusätzlichen elektro-optischen Mittel (D') bestimmt wird.

FIG.1

# FIG.2

# FIG.3

# FIG.4

# FIG.5

0 030 899

FIG.6

FIG.7

19

FIG.8

FIG.9

FIG.10

FIG.11

FIG.16

**FIG.12**

**FIG.13**

**FIG.14**

**FIG.15**